# EUROPEAN PATENT SPECIFICATION

(11) **EP 3 785 838 B1**
(45) Date of publication and mention of the grant of the patent: **20.07.2022**
(21) Application number: 19193946.1
(22) Date of filing: 27.08.2019
(51) Int. Cl.: B23K 3/06

(54) **SOLDERING ASSEMBLY, METHOD AND USE**
LÖTBAUGRUPPE, VERFAHREN UND VERWENDUNG
ENSEMBLE DE SOUDURE, PROCÉDÉ ET UTILISATION

(43) Date of publication of application: 03.03.2021
(73) Proprietor: Illinois Tool Works, Inc., Glenview, Illinois 60025 (US)
(72) Inventor: DIEPSTRATEN, Gerjan, Illinois 60025 (US)
(74) Representative: HGF

(56) References cited:
- US-A1- 2006 186 183
- US-A1- 2017 121 798

## Description

The present invention relates to a soldering assembly, a method of manufacturing a soldering assembly and a use of a soldering assemby in a soldering process.

In particular, but not exclusively, the present invention relates to a soldering assembly including a nozzle.

### Background

Selective soldering can be used in many soldering applications, for example soldering components of a Printed Circuit Board (PCB). Selective soldering can, in general, be differentiated into two methods: multi-wave dip soldering and point-to-point soldering.

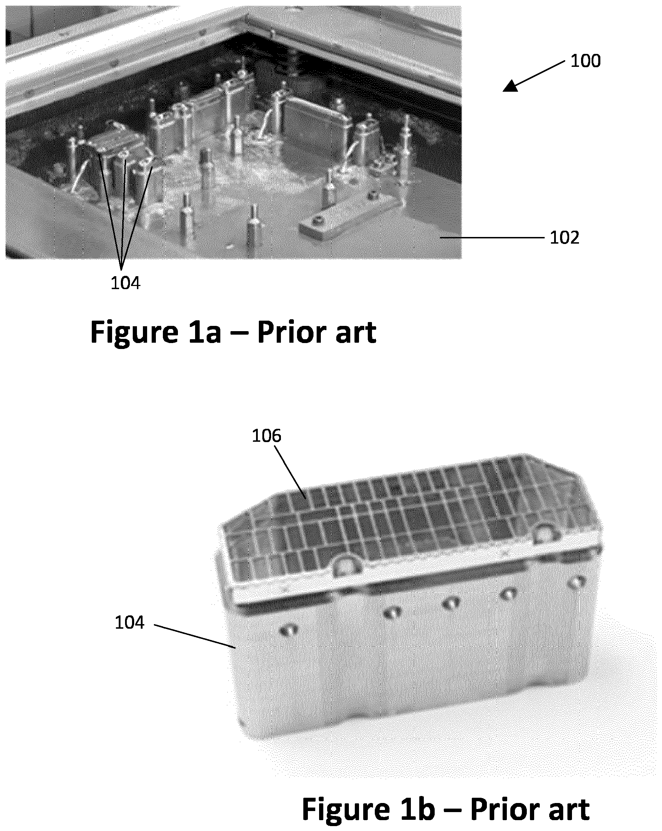

In multi-wave dip soldering processes, typically a large solder pot, or soldering assembly 100 is used (as shown in Figure 1a) having a plate 102 that includes nozzles 104 to which liquidus solder is pumped. The PCB (not shown) is lowered towards the nozzles, such that connector leads/pins (for example in a Cu - Copper - panel) are dipped into the liquidus solder present in the nozzle to form solder connections/joints at corresponding locations on the PCB. That is, multiple solder connections can be formed simultaneously. Each multi-wave dip soldering assembly has a specific nozzle plate with the nozzles being located at the required solder positions. The nozzles may have different shapes depending on the connectors to be soldered and the free space on the assembly. Figure lb illustrates a typical nozzle 104 used in a multi-wave dip soldering process. For connectors with a high risk of bridging, a laser-cut de-bridging screen 106 (provided separately from the nozzle itself) may be provided in the nozzle 104 to help avoid bridging of solder. In such examples, as the PCB is lowered towards the nozzle, the connector pins fall into the grid of the screen. Adjacent pins are separated by the gridwork of the screen, such that solder is prevented from touching the PCB material in the region between the adjacent pins (i.e. the screen is positioned between the solder mask of the PCB and the liquidus solder). As the liquidus solder is prevented from sticking to the solder mask of the PCB, the likelihood of bridge formation is reduced.

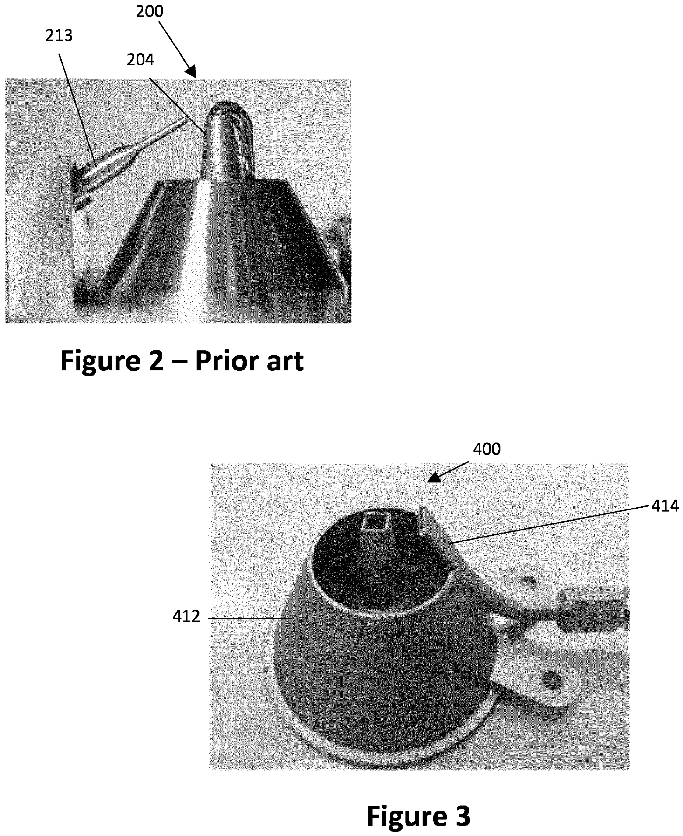

In point-to-point soldering processes, typically a small solder pot, or soldering assembly 200 (as shown in Figure 2), generally containing only one nozzle 204, is used. In contrast to multi-wave soldering where the connectors pins are dipped into the nozzle, solder overflows from the nozzle 204 and the pin is dragged through or dipped into the flowing solder (or conversely the nozzle may be moved relative to the pin). Each solder joint is soldered separately. Some known point-to-point soldering assemblies include a Solder Drainage Conditioner (SDC) 213, which projects a jet or stream of de-bridging fluid towards the nozzle outlet and soldered pins to help prevent bridging of solder between adjacent soldered connections. Current SDCs can be bulky.

Lead-free solders are very corrosive (due to the presence of Ag - Silver - and high operation temperatures). As such, components that have contact with the liquidus solder, for example the inner parts of the nozzle can be subject to corrosion/erosion. Stainless steel nozzles, in particular, are susceptible to corrosion.

In addition, current methods of manufacturing the soldering components are limited with regards to the nozzle geometry that can be produced. This can lead to sub-optimal nozzles. For example, for multi-wave dip soldering nozzles, the nozzle and screen are currently manufactured separately, which leads to a fragile screen.

US 2006/0186183 A1 (basis for the preamble of claim 1) discloses a soldering assembly comprising at least one nozzle comprising an inlet for receiving a supply of solder, an outlet for dispensing solder therefrom and at least one channel fluidly coupling the inlet to the outlet, wherein the at least one nozzle is made from stainless steel or titanium.

It would be advantageous to produce a nozzle that helps overcome the above described problems.

### Summary of the Invention

According to a first aspect of the present invention there is provided a soldering assembly comprising:
at least one nozzle for directing solder during a soldering operation, the at least one nozzle comprising:
an inlet for receiving a supply of solder;
an outlet for dispensing solder therefrom; and
at least one channel fluidly coupling the inlet to the outlet;
wherein the at least one nozzle comprises a plurality of stacked layers of stainless steel or titanium, provided so as to at least partially define the at least one channel, and wherein the at least one nozzle is at least partially diffusion coated with chromium carbide so as to protect the stacked layers from corrosion.

Suitably, the stacked layers are deposited during an additive manufacturing, or 3D printing, process.

Suitably, the at least one nozzle further comprises a de-bridging screen formed integrally therewith.

Suitably, the soldering assembly further comprises a nozzle plate.

Suitably, the soldering assembly further comprises a conduit configured to project a de-bridging fluid to an area proximate to the outlet of the nozzle, wherein the conduit comprises a plurality of stacked layers of material.

Suitably, the material is stainless steel or titanium.

Suitably, the soldering assembly further comprises a shield assembly, the shield assembly comprising:
a shield, configured to at least partially surround the nozzle, and
the conduit as described above,
wherein the conduit is integrally formed with the shield.

Suitably, the nozzle has at least one guiding portion configured to guide solder dispensed from the outlet.

Suitably, the nozzle includes at least two releasably connected parts.

According to a second aspect of the present invention there is provided a system for soldering a component, comprising
a supply of liquid solder;
a soldering assembly according to the first aspect of the invention; and
a pump apparatus, configured to pump solder from the solder supply to the at least one nozzle of the soldering assembly.

According to a third aspect of the present invention there is provided, a method of manufacturing a soldering assembly, the method comprising:
depositing layers of stainless steel or titanium in an additive manufacturing, or 3D printing, process to form at least one nozzle, for directing solder during a soldering operation, the at least one nozzle comprising:
   an inlet for receiving a supply of solder;
   an outlet for dispensing solder therefrom; and
   at least one channel fluidly coupling the inlet to the outlet; and
at least partially diffusion coating the at least one nozzle with chromium carbide so as to protect the deposited layers from corrosion.

Suitably, the method further comprises forming a de-bridging screen in the nozzle during the additive manufacturing process.

Suitably, the method further comprises depositing layers of material in an additive manufacturing, or 3D printing, process to construct a conduit configured to project a de-bridging fluid to an area proximate to the outlet of the nozzle.

Suitably, the method further comprises:
depositing layers of material in an additive manufacturing process to construct a shield assembly, the shield assembly comprising:
a shield, configured to at least partially surround the nozzle, and
the conduit as described above.

Suitably, the material is stainless steel or titanium.

According to a fourth aspect of the present invention there is provided, use of an assembly in a soldering process, the assembly comprising at least one nozzle, the at least one nozzle being formed through the deposition of layers of stainless steel or titanium in an additive manufacturing process and the diffusion coating of the at least one nozzle with chromium carbide so as to protect the deposited layers from corrosion.

Suitably, the assembly is the soldering assembly according to the first aspect of the invention.

According to a fifth aspect of the present invention there is provided an assembly for de-bridging a soldered connection (or preventing the de-bridging of a soldered component), the assembly comprising
a shield, configured to at least partially surround a nozzle for use in a soldering operation (for example that of the first aspect of the invention), and a conduit configured to project a de-bridging fluid to an area proximate to the outlet of the nozzle, wherein the conduit comprises a plurality of stacked layers of material,
wherein the conduit is integrally formed with the shield.

Certain embodiments of the invention provide the advantage that a soldering assembly is provided including a nozzle that can be produced more efficiently (for example through use of less material) compared to known nozzles.

Certain embodiments of the invention provide the advantage that a soldering assembly is provided including a nozzle that can be produced with additional functionality compared to known nozzles.

Certain embodiments of the invention provide the advantage that a soldering assembly is provided including a nozzle that has an increased lifetime compared to some known nozzles, in particular those used in combination with lead-free solder.

Certain embodiments of the invention provide the advantage that a method of manufacturing a soldering assembly is provided that allows assemblies with both an increased functionality and increased lifetime to be produced.

As used herein, when referring to 'solder' in use within a nozzle, it is to be understood that the solder is in a liquid state.

### Brief Description of the drawings

Embodiments of the invention are further described hereinafter with reference to the accompanying drawings, in which:
**Figs. 1a and 1b** illustrates a perspective view of a solder pot and a nozzle (respectively) according to the state of the art for use in multi-wave dip soldering processes;
**Fig. 2** illustrates a side view of a solder pot according to the state of the art
for use in point-to-point soldering processes;
**Figs. 3** **and** **4** illustrate perspective views of a soldering assembly for use in point-to-point soldering processes, and
**Figs. 5 to 7** illustrate profile and cross-sectional views of a nozzle of the soldering assembly of Figs. 3 and 4.

In the drawings like reference numerals refer to like parts.

### Detailed Description

In its most general form, a soldering assembly is disclosed including at least one nozzle for directing solder during a soldering operation. The soldering assembly may be a soldering assembly for use in multi-wave soldering process (typically including more than one nozzle) or point-to-point soldering processes (typically including a single nozzle).

The nozzle (or nozzles when referring to a multi-wave soldering assembly) of the present disclosure include an inlet for receiving a supply of solder, an outlet for dispensing solder therefrom and at least one channel fluidly coupling the inlet to the outlet.

The nozzle includes a plurality of stacked layers of stainless steel or titanium, provided so as to at least partially define the at least one channel. In this example, the stacked layers are deposited during an additive manufacturing, or 3D printing, process. That is, during construction, successive layers of stainless steel or titanium are deposited to build up the nozzle structure, including the bounding walls of the at least one channel.

As an example of an additive manufacturing or 3D printing process, a thin layer (for example, of 20 to 100 microns thickness) of metal powder (for example stainless steel or titanium) is laid down on top of a build-plate. The powder is melted or welded together in predetermined positions, for example by a laser or welding means. The predetermined positions may be defined by a 3D CAD model, for example. The build-plate is lowered by a distance substantially corresponding to the thickness of the thin layer and these steps are repeated. Once the required number of layers have been added, the non-melted/welded powder is removed to reveal the component inside. The component may be heat treated to improve the mechanical properties or post-processed (for example turning, milling, tumbling or shot peening).

The construction of a nozzle in this way allows different shapes and models to be produced that would generally not be possible with milling, drilling or casting processes. As such, nozzles with improved functionality may be produced. In addition, the use of materials within the printed nozzles may be more efficient.

Previously, it would have been expected that a 3D printed component, such as the nozzle of this disclosure, would have a rough surface (as a result of the addition of successive layers). As such, there would be an expectation that the roughened surface of the nozzle (in particular, the surface defining the channel) may affect the nozzles ability to produce a consistent, laminar flow of solder. However, surprisingly, this has found to not be an issue for the 3D printed nozzle.

The nozzle is at least partially diffusion coated with chromium carbide so as to protect the stacked layers from corrosion, for example from corrosive solder. The process of diffusion coating with chromium carbide is sometimes referred to as inchromizing (for example, hard inchromizing). In other words, the nozzle are at least partially hard inchromized.

In general, diffusion coating is a diffusion process where a layer of a material, for example a ceramic material is applied to a metal surface. In an inchromizing process, ceramic chromium carbide (CRxCy), for example in the form of a powder, is applied to the metal surface. In this example, the chromium carbide powder is brought into contact with the stainless steel or titanium and heated to approximately 850 °C for several hours (ranging from about 2 hours to 60 hours depending on the nozzle size). The resulting diffusion layer may have a thickness of from about 5 µm to about 25 µm. After treatment, the surface is extremely hard, densely structured and resistant to wear.

An advantage of diffusion coating over other coating methods is that bonding issues between the base material and the surface layer are reduced. In addition, diffusion coating with chromium carbide provides improved corrosion resistance over other types of protective corrosion coatings.

In some examples, the entire surface of the nozzle is diffusion coated. However, in other examples only portions of the surface of the nozzle that may come into contact with the solder are coated (for example the defining walls of the channel and portions of the exterior surface over which the solder may flow).

The expected roughened surface of the 3D printed component may have also led to doubts as to the effects of inchromizing of a 3D printed component on the microstructure of the printed nozzle. In other words, manufacturers may have been detracted from treating the nozzle in this way over concerns for the effectiveness of the corrosion resistance of the nozzle. However, surprisingly, the applicant has found that inchromizing the nozzle provides comparable results to a non-3D printed nozzle.

For example, it has been found that inchromizing the surface of the nozzle in this way makes the nozzle non-wettable, which helps extend the lifetime of nozzle. For example, the lifetime of an inchromized nozzle may be greater than 5 years in comparison to a wettable nozzle (for example made of carbon steel), which may only have a lifetime of approximately 2 weeks.

For a soldering assembly for use in multi-wave soldering process, according to the present disclosure, the assembly may include a nozzle plate, from which the nozzle (or nozzles) extend. In some examples, the nozzle plate may be 3D printed as described above, for example using stainless steel or titanium. In some areas of the nozzle plate, in particular those which have contact with solder, the nozzle plate may be inchromized in the same manner as the nozzle.

The nozzle of the multi-wave soldering assembly may include a de-bridging screen. The de-bridging screen extends at least partially over the outlet of the nozzle.

In such an example, the de-bridging screen may be formed integrally with the nozzle. That is the de-bridging screen may be formed as part of the nozzle itself. For example, the de-bridging screen may be defined by stacked layers of stainless steel or titanium, the stacked layers being deposited during the same additive manufacturing process as the nozzle itself. By providing the de-bridging screen as an integral component of the nozzle (i.e. by providing the nozzle and de-bridging screen as part of a single-piece component) the structural integrity of the de-bridging screen is improved. That is, de-bridging screens provided separately from the nozzle (and then attached/coupled thereto) can be very fragile. This fragility is reduced by providing the screen integrally with the nozzle. In other words, the structural integrity of the screen may be increased by printing the screen as an integral part of the nozzle.

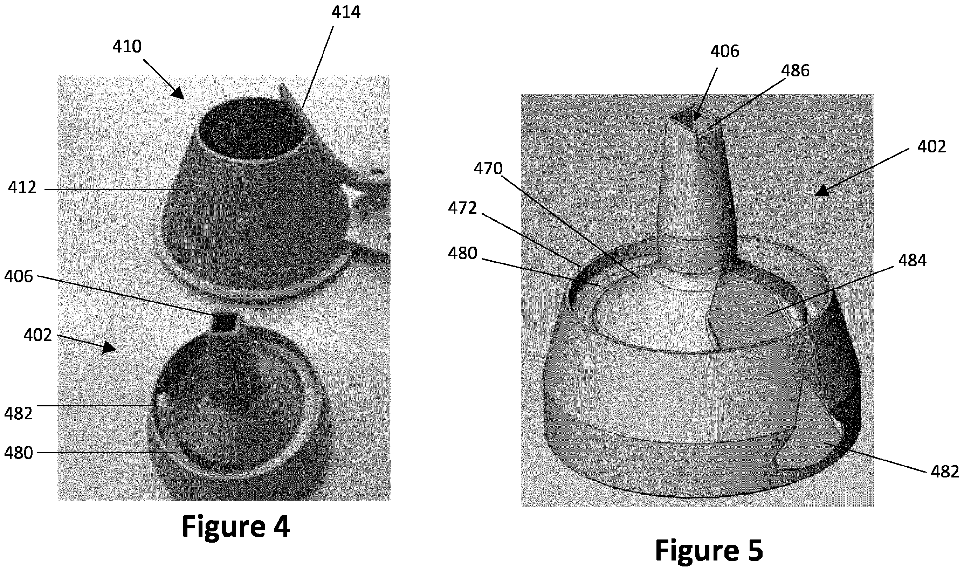

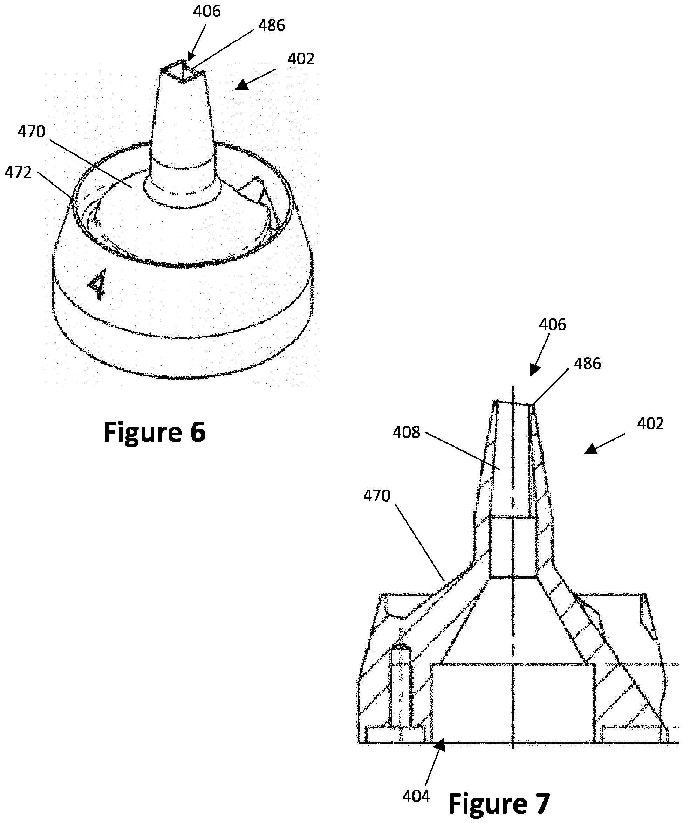

Figures 3 and 4 illustrate an example embodiment of a soldering assembly 400 of the present invention for use in a point to point soldering process. The soldering assembly 400 includes a 3D printed, coated, nozzle 402, with an inlet 404, outlet 406 and channel 408 (i.e. of the general type described above). The nozzle 402 of the soldering assembly 400 is illustrated in Figures 5 to 7.

During a soldering process, the nozzle 402 is arranged such that solder flows in a generally upward direction towards, and subsequently from, the nozzle outlet 406. As the solder is dispensed from the nozzle outlet 406, the solder flows over an over-flow section of the nozzle 402 before flowing in a generally downwardly direction along (or adjacent to) an exterior surface of the nozzle (i.e. due to gravity). In general, the connector pin to be soldered is dragged through or dipped into the flowing solder after the solder has flowed at least partially over the over-flow section.

As used herein, it is to be understood that an 'over-flow section' is a section of the outlet over which solder flows as the solder 'over-flows' from the nozzle outlet. The over-flow section may be an edge (for example a peripheral edge of the outlet), a section of the edge, or a surface connected to the edge.

In this example, the exterior surface of the nozzle includes at least one guiding portion configured to guide solder dispensed from the outlet 406. The guiding portion may be a channel, groove, flat guiding surface or similar.

In this example, the nozzle includes a body portion 470. The body portion is surrounded by a side wall portion 472. At the junction between the body portion 470 and the raised wall portion 472 is defined a first guiding portion, channel 480 configured to guide solder dispensed from the outlet 406. The channel 480 extends around an exterior surface of the nozzle 402 and guides the over-flowing liquid solder back into the supply of liquid solder (i.e. a solder pot or reservoir). In other words, the channel portion 480 is configured to function as a gutter, positioned around body portion 470 of the nozzle 402 to guide the solder smoothly back to the solder supply.

The solder may, for example, be guided back to the solder supply through an opening 482 in the side wall portion 472 of the channel portion 480.

The body portion 470 and side wall portion 472 are integral parts of the nozzle 402. That is, the channel 480 is defined by stacked layers of stainless steel or titanium being deposited during the additive manufacturing process of the nozzle 402 itself. The use of 3D printing to produce the nozzle 402 allows the straightforward inclusion of such channels/gutters within the exterior surface of the nozzle. In addition, 3D printing enables more specific, or complex, gutter geometry to be included in the nozzle, which may help ensure laminar flow of the liquid solder. This allows smooth flow of solder back into solder pot and hence reduces splattering of solder which may result in solder balls on the bottom side of the assembly.

In this example, the nozzle 402 includes a second guiding portion, guiding surface 484. In this example the guiding surface 484 is a flat section on the body portion 470 that extends longitudinally along the exterior of the nozzle 402. In this example, the guiding surface 484 is longitudinally aligned with (i.e. extends downwardly from) the over-flow edge 486. As such, as the solder flows over the over-flow edge 486, the solder may flow downwardly along the guiding surface back to the solder supply.

In this example, the soldering assembly 400 further includes a shield assembly 410, including a shield 412, configured to at least partially surround the nozzle 402. In particular, the shield 412 is configured to at least partially surround the sides (i.e. the side wall portion 472) of the nozzle 402, allowing the nozzle to extend through the bore, or hollowed interior, of the shield 412. In this example, the shield 412 has a hollow, truncated cone profile. However, in other examples the shield 412 may have other profiles, for example cylindrical.

In use, the shield 412 is configured to contain splattering of solder from the nozzle 402 and help guide solder from the nozzle 402 back to the solder supply.

The shield 412 may be manufactured in any suitable manner (for example, through machining or casting). However, in this example the shield 412 may itself include a plurality of stacked layers deposited during an additive manufacturing, or 3D printing, process. The stacked layers may be stainless steel or titanium, for example.

In this example, as illustrated in Figure 4, the shield assembly 410 is separate from the nozzle 402. That is, the shield assembly 410 is formed separately from the nozzle 402 and then the soldering assembly 400 (including the nozzle 402 and shield assembly 410) is assembled prior to use. However, in other examples, the shield assembly 410 and the nozzle 402 may be formed integrally. That is, the shield 412 may be defined by stacked layers of stainless steel or titanium, the stacked layers being deposited during the same additive manufacturing process as the nozzle 402 itself.

In this example, the shield assembly 410 further includes a conduit 414 configured to project, emit or dispense a de-bridging fluid. In this example, the conduit 414 has a first end configured to be coupled to a supply of de-bridging fluid, for example an inert gas stream such as nitrogen. The conduit 414 has a second end positioned proximate to the nozzle outlet 406. In use, the de-bridging fluid is supplied from the fluid supply through the conduit 414 and projected as a stream or jet of de-bridging fluid from the second end of the conduit 414. The supply of de-bridging fluid may be continuous or intermittent (for example, corresponding to the soldering of connector pins). In some examples, the temperature and/or velocity of the stream of de-bridging fluid are adjustable.

The conduit 414 is configured to project the de-bridging fluid to an area proximate to the outlet 406 of the nozzle 402. That is, the jet or stream of de-bridging fluid is directed or angled towards an area proximate to the outlet 406 of the nozzle 402. In doing so, the jet or stream of de-bridging fluid is projected towards components recently soldered by the over-flowing stream of solder dispensed from the outlet. For example, when the soldering assembly is being used to solder connector pins on a PCB, as the connector pins emerge from the over-flowing stream of solder, the connector pins are impinged by the de-bridging fluid. In this example, in use, the conduit 414 is pointed / angled so as to direct the jet or stream of de-bridging fluid in the opposite direction to the relative movement between the PCB and the nozzle.

As the de-bridging fluid impinges the soldered components, bridging between adjacent soldered components (for example, adjacent connector pins within a row of connector pins, soldered in succession) is reduced, or prevented. That is, when the overflowing solder bridges adjacent connector pins, it may become unstable, with this instability being corrected by the impinging de-bridging fluid. In addition, the use of a hot gas (for example nitrogen at a temperature of more than about 230 degrees Celsius, corresponding generally to liquidus temperature of solder) as the de-bridging fluid improves thermal solderability.

In this example, the second end of the conduit is substantially flattened. That is, the conduit 414 has a generally tubular profile, with the second tubular end being flattened to provide a more concentrated flow therefrom.

In this example the conduit 414 is a 3D printed component. In other words, the conduit 414 includes a plurality of stacked layers deposited during an additive manufacturing, or 3D printing, process. The stacked layers may be stainless steel or titanium, for example.

In this example, the conduit is supported by the shield 412, the second end of the conduit extending above the upper portion of the shield 412. In other words, in use, the second end of the conduit 412 extends above the top of the shield 412 and projects towards the nozzle outlet. The shield 412 helps provide an inert environment in the solder area. That is, the de-bridging fluid is blown in the solder-pot and will escape along the nozzle. The shield reduces the oxygen level and avoids oxidation during soldering and helps promote the solder wetting.

In this example, the conduit 414 is integrally formed with the shield 412. That is, the shield 412 and the conduit 414 are defined by stacked layers (for example of stainless steel or titanium) deposited during the same additive manufacturing process. By 3D printing the conduit 414 as part of the shield 412, the space required for the de-bridging unit is reduced. That is, the conduit 414, supported by the shield 412, replaces a much larger nitrogen unit (SDC), which would include a separate bracket for supporting the conduit.

In addition, the 3D printed conduit 414 makes it easier to maintain the temperature of the de-bridging fluid above the liquidus temperature of the solder to make de-bridging possible. In particular, previous SDC designs were larger (for example including a separate mounting bracket) and hence included a larger mass of metal. Due to the high mass of metal, the heat in the SDC was at least partially dispersed prior to reaching the conduit (or the end of the conduit). 3D printing the conduit 414, allows different designs to be implemented (for example a conduit with a flattened end and/or a conduit integrated within the shield) that doesn't absorb so much heat. The heater can therefore have lower setpoints to achieve the required nitrogen temperature.

The nozzles described above are configured for use in a system for soldering a component, the system further including a supply of liquid solder, a pump apparatus, configured to pump solder from the solder supply to the nozzle (or more specifically to the outlet of the nozzle). The system may, for example, be of a type known in the art, for example a Vitrionics Soltec ZEVAm (for a point-to-point soldering process) or a Vitrionics Soltec ZEVAv (for a multi-wave soldering process). The system may be used to solder PCBs.

### Modifications

Various modifications to the detailed designs as described above are possible. For example, the entire soldering assembly may be 3D printed and then diffusion coated. That is, the soldering assembly may include a plurality of stacked layers of stainless steel or titanium, provided so as to at least partially define the at least one channel, the soldering assembly being at least partially diffusion coated with chromium carbide so as to protect the stacked layers from corrosion. In other examples, components of the soldering assembly that, generally, do not contact solder, may instead be 3D printed with stainless steel or titanium without coating.

In some examples, components of the soldering assembly, for example the nozzle, may be formed of two releasably connected parts. For example, the nozzle may include two or more sub-components, that couple together in use, but between uses can be de-coupled or separated to allow for maintenance. For example, the nozzle may include top and bottom portions that couple axially, or two or more side portions that couple longitudinally.

It would be understood that when referring to stainless steel in the examples above, any suitable grade of stainless steel may be used, for example A316 stainless steel.

It will be clear to a person skilled in the art that features described in relation to any of the embodiments described above can be applicable interchangeably between the different embodiments. The embodiments described above are examples to illustrate various features of the invention as defined in the claims.

Throughout the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

## Claims

1. A soldering assembly (400) comprising:
at least one nozzle (402) for directing solder during a soldering operation, the at least one nozzle (402) comprising:
an inlet (404) for receiving a supply of solder;
an outlet (406) for dispensing solder therefrom; and
at least one channel (408) fluidly coupling the inlet (404) to the outlet (406);
wherein the at least one nozzle (402) comprises a plurality of stacked layers of stainless steel or titanium, provided so as to at least partially define the at least one channel (408), and
wherein the at least one nozzle (402) is at least partially diffusion coated with chromium carbide so as to protect the stacked layers from corrosion.

2. A soldering assembly (400) according to claim 1, wherein the stacked layers are deposited during an additive manufacturing, or 3D printing, process.

3. A soldering assembly (400) according to any preceding claim, wherein the at least one nozzle (402) further comprises a de-bridging screen formed integrally therewith.

4. A soldering assembly (400) according to any preceding claim, wherein the soldering assembly (400) further comprises a nozzle plate.

5. A soldering assembly (400) according to claim 1 or 2,
wherein the soldering assembly (400) further comprises a conduit (414) configured to project a de-bridging fluid to an area proximate to the outlet (406) of the nozzle (402),
wherein the conduit (414) comprises a plurality of stacked layers of material.

6. A soldering assembly (400) according claim 5, wherein the soldering assembly (400) further comprises a shield assembly (410), the shield assembly (410) comprising:
a shield (412), configured to at least partially surround the nozzle (402), and
the conduit (414) of claim 5,
wherein the conduit (414) is integrally formed with the shield (412).

7. A soldering assembly (400) according to any proceeding claim, wherein the nozzle (402) has at least one guiding portion configured to guide solder dispensed from the outlet (406).

8. A soldering assembly (400) according to any preceding claim, wherein the nozzle (402) includes at least two releasably connected parts.

9. A system for soldering a component, comprising
a supply of liquid solder;
a soldering assembly (400) according to any of claims 1 to 8; and
a pump apparatus, configured to pump solder from the solder supply to the at least one nozzle (402) of the soldering assembly (400).

10. A method of manufacturing a soldering assembly (400), the method comprising:
depositing layers of stainless steel or titanium in an additive manufacturing,
or 3D printing, process to form at least one nozzle (402), for directing solder during a soldering operation, the at least one nozzle (402) comprising:
an inlet (404) for receiving a supply of solder;
an outlet (406) for dispensing solder therefrom; and
at least one channel (408) fluidly coupling the inlet (404) to the outlet (406); and
at least partially diffusion coating the at least one nozzle (402) with chromium carbide so as to protect the deposited layers from corrosion.

11. A method according to claim 10, wherein the method further comprises forming a de-bridging screen in the nozzle (402) during the additive manufacturing process.

12. A method according to claim 10 or 11, wherein the method further comprises:
depositing layers of material in an additive manufacturing, or 3D printing, process to construct a conduit (414) configured to project a de-bridging fluid to an area proximate to the outlet (406) of the nozzle (402).

13. A method according to claim 12, wherein the method further comprises:
depositing layers of material in an additive manufacturing process to construct a shield assembly (410), the shield assembly (410) comprising:
a shield (412), configured to at least partially surround the nozzle (402), and
the conduit (414) of claim 12.

14. Use of an assembly in a soldering process, the assembly comprising at least one nozzle (402), the at least one nozzle (402) being formed through the deposition of layers of stainless steel or titanium in an additive manufacturing process and the diffusion coating of the at least one nozzle (402) with chromium carbide so as to protect the deposited layers from corrosion.

15. Use of an assembly according to claim 14, wherein the assembly is the soldering assembly (400) of any of claims 1 to 8.

## Patentansprüche

1. Lötbaugruppe (400), aufweisend:
zumindest eine Düse (402) zum Richten von Lötmittel während eines Lötvorgangs, die zumindest eine Düse (402) aufweisend:
einen Einlass (404) zur Aufnahme eines Vorrats an Lötmittel;
einen Auslass (406) zum Ausgeben von Lötmittel daraus; und
zumindest einen Kanal (408), der den Einlass (404) mit dem Auslass (406) fluidisch koppelt;
wobei die zumindest eine Düse (402) eine Vielzahl von gestapelten Schichten aus rostfreiem Stahl oder Titan aufweist, die so bereitgestellt sind, dass sie zumindest teilweise den zumindest einen Kanal (408) definieren, und
wobei die zumindest eine Düse (402) zumindest teilweise mit Chromcarbid diffusionsbeschichtet ist, um die gestapelten Schichten vor Korrosion zu schützen.

2. Lötbaugruppe (400) nach Anspruch 1, wobei die gestapelten Schichten während eines additiven Herstellungs- oder 3D-Druckprozesses aufgebracht werden.

3. Lötbaugruppe (400) nach einem der vorhergehenden Ansprüche, wobei die zumindest eine Düse (402) ferner ein damit einstückig ausgebildetes Entbrückungssieb aufweist.

4. Lötbaugruppe (400) nach einem der vorhergehenden Ansprüche, wobei die Lötbaugruppe (400) ferner eine Düsenplatte aufweist.

5. Lötbaugruppe (400) nach Anspruch 1 oder 2,
wobei die Lötbaugruppe (400) ferner eine Leitung (414) aufweist, die so konfiguriert ist, dass sie ein Entbrückungsfluid zu einem Bereich in der Nähe des Auslasses (406) der Düse (402) projiziert,
wobei die Leitung (414) eine Vielzahl von gestapelten Materialschichten aufweist.

6. Lötbaugruppe (400) nach Anspruch 5, wobei die Lötbaugruppe (400) ferner eine Abschirmbaugruppe (410) aufweist, die Abschirmbaugruppe (410) aufweisend:
eine Abschirmung (412), die so konfiguriert ist, dass sie die Düse (402) und die Leitung (414) nach Anspruch 5 zumindest teilweise umgibt,
wobei die Leitung (414) integral mit der Abschirmung (412) ausgebildet ist.

7. Lötbaugruppe (400) nach einem der vorhergehenden Ansprüche, wobei die Düse (402) zumindest einen Führungsabschnitt hat, der so konfiguriert ist, dass er aus dem Auslass (406) ausgegebenes Lötmittel führt.

8. Lötbaugruppe (400) nach einem der vorhergehenden Ansprüche, wobei die Düse (402) zumindest zwei lösbar verbundene Teile beinhaltet.

9. System zum Löten eines Bauteils, aufweisend
einen Vorrat an flüssigem Lötmittel;
eine Lötbaugruppe (400) nach einem der Ansprüche 1 bis 8; und eine Pumpvorrichtung, die so konfiguriert ist, dass sie Lötmittel vom Lötmittelvorrat zu der zumindest einen Düse (402) der Lötbaugruppe (400) pumpt.

10. Verfahren zur Herstellung einer Lötbaugruppe (400), das Verfahren aufweisend:
Abscheiden von Schichten aus rostfreiem Stahl oder Titan in einem additiven Herstellungs- oder 3D-Druckprozess, um zumindest eine Düse (402) auszubilden, zum Richten von Lötmittel während eines Lötvorgangs, die zumindest eine Düse (402) aufweisend:
einen Einlass (404) zur Aufnahme eines Vorrats an Lötmittel;
einen Auslass (406) zum Ausgeben von Lötmittel daraus; und
zumindest einen Kanal (408), der den Einlass (404) mit dem Auslass (406) fluidisch koppelt; und
eine zumindest teilweise Diffusionsbeschichtung der zumindest einen Düse (402) mit Chromcarbid, um die abgeschiedenen Schichten vor Korrosion zu schützen.

11. Verfahren nach Anspruch 10, wobei das Verfahren ferner das Ausbilden eines Entbrückungssiebs in der Düse (402) während des additiven Herstellungsprozesses aufweist.

12. Verfahren nach Anspruch 10 oder 11, das Verfahren ferner aufweisend:
das Abscheiden von Materialschichten in einem additiven Herstellungs- oder 3D-Druckprozess, um eine Leitung (414) aufzubauen, die so konfiguriert ist, dass sie ein Entbrückungsfluid zu einem Bereich in der Nähe des Auslasses (406) der Düse (402) projiziert.

13. Verfahren nach Anspruch 12, wobei das Verfahren ferner aufweist:
Abscheiden von Materialschichten in einem additiven Herstellungsprozess, um eine Abschirmbaugruppe (410) zu konstruieren, die Abschirmbaugruppe (410) aufweisend:
eine Abschirmung (412), die so konfiguriert ist, dass sie die Düse (402) und die Leitung (414) nach Anspruch 12 zumindest teilweise umgibt.

14. Verwendung einer Baugruppe in einem Lötprozess, wobei die Baugruppe zumindest eine Düse (402) aufweist, wobei die zumindest eine Düse (402) durch Abscheidung von Schichten aus rostfreiem Stahl oder Titan in einem additiven Herstellungsprozess und die Diffusionsbeschichtung der zumindest einen Düse (402) mit Chromcarbid ausgebildet wird, um die abgeschiedenen Schichten vor Korrosion zu schützen.

15. Verwendung einer Baugruppe nach Anspruch 14, wobei die Baugruppe die Lötbaugruppe (400) nach einem der Ansprüche 1 bis 8 ist.

## Revendications

1. Ensemble de soudage (400) comprenant :
au moins une buse (402) pour diriger la soudure durant une opération de soudage, l'au moins une buse (402) comprenant :
une entrée (404) pour la réception d'une alimentation de soudure ;
une sortie (406) pour la distribution de soudure à partir de celle-ci ; et
au moins un canal (408) couplant de manière fluide l'entrée (404) à la sortie (406) ;
dans lequel l'au moins une buse (402) comprend une pluralité de couches empilées d'acier inoxydable ou de titane, fournies de façon à définir au moins partiellement l'au moins un canal (408), et
dans lequel l'au moins une buse (402) est au moins partiellement revêtue par diffusion avec du carbure de chrome de façon à protéger les couches empilées de la corrosion.

2. Ensemble de soudage (400) selon la revendication 1, dans lequel les couches empilées sont déposées durant un processus de fabrication additive, ou d'impression 3D.

3. Ensemble de soudage (400) selon l'une quelconque des revendications précédentes, dans lequel l'au moins une buse (402) comprend en outre un écran de dévoutage formé d'un seul tenant avec celle-ci.

4. Ensemble de soudage (400) selon l'une quelconque des revendications précédentes, dans lequel l'ensemble de soudage (400) comprend en outre une plaque de buse.

5. Ensemble de soudage (400) selon la revendication 1 ou 2, dans lequel l'ensemble de soudage (400) comprend en outre un conduit (414) configuré pour projeter un fluide de dévoutage vers une zone proche de la sortie (406) de la buse (402), dans lequel le conduit (414) comprend une pluralité de couches de matériau empilées.

6. Ensemble de soudage (400) selon la revendication 5, dans lequel l'ensemble de soudage (400) comprend en outre un ensemble de protection (410), l'ensemble de protection (410) comprenant :
une protection (412), configurée pour entourer au moins partiellement la buse (402), et le conduit (414) selon la revendication 5,
dans lequel le conduit (414) est formé d'un seul tenant avec la protection (412).

7. Ensemble de soudage (400) selon l'une quelconque des revendications précédentes, dans lequel la buse (402) a au moins une partie de guidage configurée pour guider la soudure distribuée à partir de la sortie (406).

8. Ensemble de soudage (400) selon l'une quelconque des revendications précédentes, dans lequel la buse (402) comprend au moins deux parties reliées de manière amovible.

9. Système de soudage d'un élément, comprenant
une alimentation de soudure liquide ;
un ensemble de soudage (400) selon l'une quelconque des revendications 1 à 8 ; et
un appareil de pompage, configuré pour pomper de la soudure à partir de l'alimentation en soudure vers l'au moins une buse (402) de l'ensemble de soudage (400).

10. Procédé de fabrication d'un ensemble de soudage (400), le procédé comprenant :
le dépôt de couches d'acier inoxydable ou de titane dans un processus de fabrication additive, ou
d'impression 3D, pour former au moins une buse (402), pour la direction de la soudure durant une opération de soudage, l'au moins une buse (402) comprenant :
une entrée (404) pour la réception d'une alimentation de soudure ;
une sortie (406) pour la distribution de soudure à partir de celle-ci ; et
au moins un canal (408) couplant de manière fluide
l'entrée (404) à la sortie (406) ; et
au moins partiellement le revêtement par diffusion de l'au moins une buse (402) avec du carbure de chrome de façon à protéger les couches déposées de la corrosion.

11. Procédé selon la revendication 10, dans lequel le procédé comprend en outre la formation d'un écran de dévoutage dans la buse (402) durant le processus de fabrication additive.

12. Procédé selon la revendication 10 ou 11, dans lequel le procédé comprend en outre :
le dépôt de couches de matériau dans un processus de fabrication additive, ou d'impression 3D, pour construire un conduit (414) configuré pour projeter un fluide de dévoutage vers une zone proche de la sortie (406) de la buse (402).

13. Procédé selon la revendication 12, dans lequel le procédé comprend en outre :
le dépôt de couches de matériau dans un processus de fabrication additive pour construire un ensemble de protection (410), l'ensemble de protection (410) comprenant :
une protection (412), configurée pour entourer au moins partiellement la buse (402), et le conduit (414) selon la revendication 12.

14. Utilisation d'un ensemble dans un processus de soudage, l'ensemble comprenant au moins une buse (402), l'au moins une buse (402) étant formée à travers le dépôt de couches d'acier inoxydable ou de titane dans un processus de fabrication additive et le revêtement par diffusion de l'au moins une buse (402) avec du carbure de chrome de façon à protéger les couches déposées de la corrosion.

15. Utilisation d'un ensemble selon la revendication 14, dans laquelle l'ensemble est l'ensemble de soudage (400) selon l'une quelconque des revendications 1 à 8.
